# EUROPEAN PATENT SPECIFICATION

(11) **EP 2 339 902 B1**
(45) Date of publication and mention of the grant of the patent: **03.04.2013**
(21) Application number: 10194402.3
(22) Date of filing: 09.12.2010
(51) Int. Cl.: H05K 1/14, H05K 3/36, H05K 3/40

(54) **Printed wiring board connecting structure**
Verbindungsstruktur für Druckleiterplatten
Structure de connexion de cartes de circuit imprimé

(30) Priority: 17.12.2009 JP 2009286717
(43) Date of publication of application: 29.06.2011
(73) Proprietor: Panasonic Corporation, Osaka 571-8501 (JP)
(72) Inventor: Kamoi, Takeshi, Fushimi-ku Kyoto 612-8081 (JP); Hasegawa, Junichi, Kashiwara Osaka (JP); Kumagai, Jun, Suita Osaka 565-0821 (JP); Sato, Kenji, Himeji Hyogo (JP)
(74) Representative: Rüger, Barthelt & Abel

(56) References cited:
- US-A1- 2006 128 174
- US-B1- 6 496 384

## Description

### [Field of the Invention]

The present invention relates to a printed wiring board connecting structure that electrically and mechanically connects a plurality of printed wiring boards.

### [Background Art]

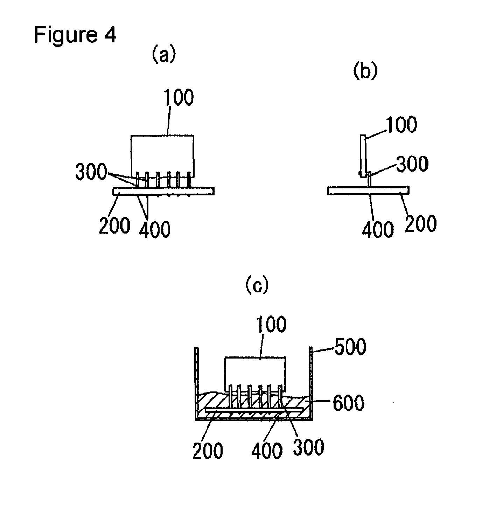

US 6 496 384 shows a printed wiring board connecting structure including: a first printed wiring board having a one connecting area with a first connecting pattern made of an electrically conductive material, the first connecting pattern being formed on both surfaces in a thickness direction. A second printed wiring board is provided having one connecting hole that penetrate in a thickness direction and are to be inserted with the respective connecting area. The printed wiring board connecting structure is configured such that a circumferential part and an inner circumferential surface of the connecting hole is formed with a second connecting pattern that is to be electrically connected to the first connecting pattern and made of an electrically conductive material. By inserting the connecting area into the connecting hole, and soldering the first connecting pattern to the second connecting pattern, the first printed wiring board and the second printed wiring board are electrically and mechanically connected to each other. The connecting area has through-holes that are arranged in one row along the edge of the connecting area and penetrate in the thickness direction and respectively have inner circumferential surfaces which can be covered with an electrically conductive material, and upon the soldering, parts of the through-holes are exposed outside the connecting hole.
There is conventionally known a technique that makes an electrical and mechanical connection between a printed wiring board (mother board) mounted with various integrated circuits and other electronic circuit parts and a printed wiring board (child board) constituting an integrated circuit such as a hybrid integrated circuit (HIC). In the following, some conventional examples of such a printed wiring board connecting structure are described with use of drawings. Note that, in the following description, a direction between the top and bottom in Fig. 4 (a) is defined as a vertical direction.

In a first conventional example, as illustrated in Figs. 4 (a) and (b), a child board 100 is provided with a plurality of external terminals 300 each of which protrudes from one end part (lower end part) of the child board 100 itself and has a substantially L-shaped cross section. Also, a mother board 200 is provided with a plurality of through-holes (not illustrated) into which the external terminals 300 are to be inserted. Accordingly, by inserting the external terminals 300 into the through-holes and soldering them with solder 400 on a lower surface side of the mother board 200, the respective boards 100 and 200 are electrically and mechanically connected to each other. The respective boards 100 and 200 connected in this manner are, as illustrated in Fig. 4 (c), contained in a case 500, and by filling resin 600 in the case500, improved in insulating, radiation, and waterproof properties. According to the above-described configuration, by the soldering from the lower surface side of the mother board 200, the solder 400 moves up to an upper surface of the mother board 200 through the through-holes, and is filled in the entire through-holes. However, the above first conventional example has a problem that the child board 100 should be mounted with the external terminals 300, and is therefore increased in size.

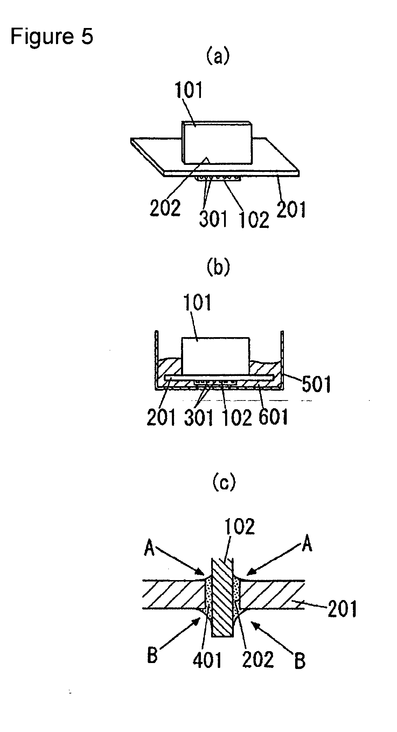

As a structure for solving the problem of the above first conventional example, there is a second conventional example described below. In the second conventional example, as illustrated in Fig. 5 (a), a child board 101 is provided with a plate-like connecting piece 102 that protrudes from one end edge (lower end edge) of the child board 101 itself and is formed with pluralities of connecting patterns 301 on both surfaces in a thickness direction thereof. Also, the mother board 201 is provided with a connecting hole 202 into which the connecting piece 102 is to be inserted. Accordingly, by inserting the connecting piece 102 into the connecting hole 202, and soldering the connecting patterns 301 to connecting patterns (not illustrated) on a lower surface side of the mother board 201, the respective boards are electrically and mechanically connected to each other. The respective boards 101 and 201 connected in this manner are, as illustrated in Fig. 5 (b), contained in a case 501, and by filling resin 601 in the case 501, improved in insulating, radiation, and waterproof properties. Further, there is also a structure provided with, in addition to the configuration of the above second conventional example, a positioning part that, to prevent an inserting position of the child board 101 into the mother board 201 from being displaced, positions the child board 101 with respect to the mother board 201 (see Patent Literature 1).

In the above second conventional example, the connecting patterns 301 are provided on the child board 101 to thereby constitute the connecting piece 102, so that it is not necessary to mount the external terminals 300 on the child board 100 as in the first conventional example, and therefore the child board 101 can be prevented from being increased in size. However, in the second conventional example, the connecting patterns 301 are provided only on the both surfaces in the thickness direction of the connecting piece 102. For this reason, as illustrated in Fig. 5 (c), an amount of the solder 401 in sites near both surfaces in a thickness direction of the mother board 201 is insufficient. When the resin 601 is filled in the case 501, the resin 601 is expanded or contracted by a temperature difference occurring between circuit operation and stop states, and thereby connecting sites of the respective boards 101 and 201 are applied with stress. In this case, there is a problem that the stress is applied in directions indicated by arrows A and B in the diagram, and therefore cracks are likely to occur at the above sites where the amount of the solder 401 is insufficient.

As a structure for solving the problem of the above second conventional example, there is a third conventional example described below (see Patent Literature 2). In the third conventional example, as illustrated in Figs. 6 (a) and (b), a child board 103 is provided with a plurality of connecting pieces 104 that protrude from one end edge (lower end edge) of the child board 103 itself. Also, a mother board 203 is provided with a plurality of connecting holes (not illustrated) into which the respective connecting pieces are to be inserted. Accordingly, by inserting the connecting pieces 104 into the connecting holes, and soldering them on a lower surface side of the mother board 203, the respective boards 103 and 203 are electrically and mechanically connected to each other. Note that an entire surface of each of the connecting pieces 104 is covered with an electrically conductive material, in particular, metal, and the cover constitutes a connecting pattern. For this reason, by the soldering from the lower surface side of the mother board 203, solder moves up to an upper surface of the mother board 203 through the connecting holes, and is filled in the entire connecting holes. Accordingly, differently from the above, cracks are unlikely to occur, which results in good and reliable electrical connections between the respective boards.

### [Conventional Technique Literature]

### [Patent Literature]

[Patent Literature 1] JPU-Heisei 7-7166
[Patent Literature 2] JPT-2004-505471

### [Disclosure of the Invention]

### [Problems to be solved by the Invention]

However, in the above third conventional example, the entire surface of each of the connecting pieces 104 should be applied with the cover made of the electrically conductive material, and therefore not only both surfaces in a thickness direction of each of the connecting pieces 104, but also side surfaces should be applied with the cover. For this reason, there is a problem that a man-hour necessary to manufacture the child board 103 is increased, which makes it difficult to manufacture the board.

The present invention is made in consideration with the above point, and has an object to provide a printed wiring board connecting structure that enables a board to be easily manufactured, and good and reliable electrical connections to be achieved.

### [Means adapted to solve the Problems]

In order to accomplish the above object, according to a first aspect of the present invention, a printed wiring board connecting structure including: a first printed wiring board having a plurality of connecting pieces each formed with a first connecting pattern made of an electrically conductive material, the first connecting pattern being formed on both surfaces in a thickness direction; and a second printed wiring board having a plurality of connecting holes that are to be inserted with the respective connecting pieces, the printed wiring board connecting structure being configured such that a circumferential part and an inner circumferential surface of each of the connecting holes is formed with a second connecting pattern that is to be electrically connected to the first connecting pattern and made of an electrically conductive material, and by inserting each of the connecting pieces into each of the connecting holes, and soldering the first connecting pattern to the second connecting pattern, the first printed wiring board and the second printed wiring board are electrically and mechanically connected to each other, wherein the connecting pieces respectively have through-holes that penetrate in the thickness direction and respectively have inner circumferential surfaces covered with an electrically conductive material, and upon the soldering, parts of the through-holes are exposed outside the connecting holes, wherein each of the connecting pieces has a plurality of through-holes; a part of at least one of the through-holes is, upon the soldering, exposed on one side in the thickness direction of the second printed wiring board; and a part of at least one of the other through-holes is, upon the soldering, exposed on the other side in the thickness direction of the second printed wiring board.

According to a second aspect of the present invention, each of the connecting pieces has one through-hole, the through-hole has an elliptical shape in a plan view, the elliptical shape having a major diameter in the thickness direction of the second printed wiring board and parts of the through-hole are, upon the soldering, exposed on both sides in the thickness direction of the second printed wiring board.

### [Effect of the Invention]

According to the present invention, upon the soldering, solder is filled in through-holes, and sites near the both surfaces in a thickness direction of a second printed circuit board in connecting sites are joined by the solder through the through-holes, and therefore in joint areas, a sufficient amount of the solder can be ensured to enhance joint strength. For this reason, even if stress is externally applied to the connecting sites, a failure such as a crack does not occur, and therefore good and reliable electrical connections can be achieved. Also, it is not necessary to apply covers to entire surfaces of connecting pieces as in a conventional case, and therefore a board can be easily manufactured.

### [Brief Description of the Drawings]

[Fig. 1] Fig. 1 is a diagram illustrating a first embodiment of a printed wiring board connecting structure according to the present invention, in which (a) is a perspective view, and (b) is a front view in a state where connecting pieces are inserted.
[Fig. 2] Fig. 2 is a diagram illustrating a main part in a state after soldering in the first embodiment, in which (a) is a front view, (b) is a side view, and (c) is a cross-sectional view.
[Fig. 3] Fig. 3 is a diagram illustrating a second embodiment of the printed wiring board connecting structure according to the present invention, in which (a) is an overall perspective view, (b) is a front view in a state where connecting pieces are inserted, and (c) is a cross-sectional view of a main part.
[Fig. 4] Fig. 4 is a diagram illustrating a printed wiring board connecting structure according to a first conventional example, in which (a) is a front view, (b) is a side view, and (c) is a cross-sectional view in a state where respective printed wiring boards are contained in a case.
[Fig. 5] Fig. 5 is a diagram illustrating a printed wiring board connecting structure according to a second conventional example, in which (a) is a perspective view, (b) is a cross-sectional view in a state where respective printed wiring boards are contained in a case, and (c) is a cross-sectional view of a main part.

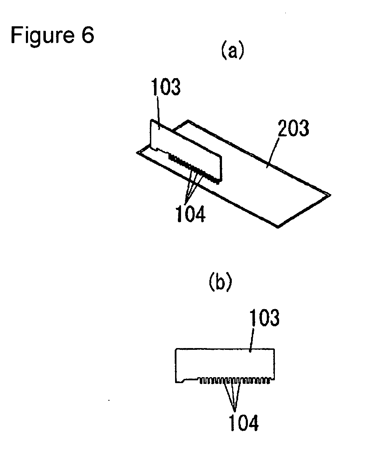

[Fig. 6] Fig. 6 is a diagram illustrating a printed wiring board connecting structure according to a third conventional example, in which (a) is a perspective view, and (b) is a front view of a child board.

### [Best Mode for Carrying Out the Invention]

### (First embodiment)

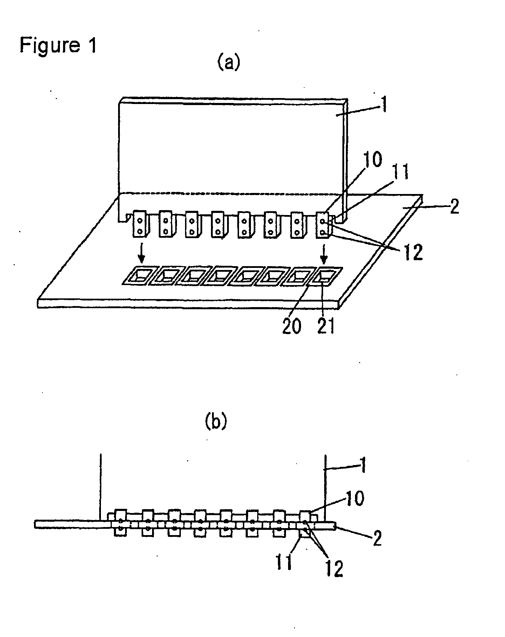

A first embodiment of a printed wiring board connecting structure according to the present invention is described below with use of the drawings. Note that, in the following description, directions between the top and bottom and between the right and left in Fig. 1 (b) are respectively defined as vertical and horizontal directions, and directions toward front and rear sides of the diagram are respectively defined as front and rear directions. The present embodiment includes, as illustrated in Figs. 1 (a) and (b), a child board 1 serving as a first printed wiring board and a mother board 2 serving as a second printed wiring board, in which the respective boards are electrically and mechanically connected to each other by soldering.

The child board 1 constitutes, for example, a hybrid integrated circuit (HIC), and from one end edge (lower end edge) thereof, a plurality of (eight in the diagram) connecting pieces 11 are integrally protruded. Each of the connecting pieces 11 is formed in a rectangular plate-like shape, and both surfaces in a thickness direction (front/rear direction) thereof are formed with a first connecting pattern 10 made of an electrically conductive material. Also, in each of the connecting pieces 11, a pair of through-holes 12 each of which penetrates in the thickness direction and is circular-shaped in a plan view are provided at a predetermined interval along a longer direction (vertical direction) of the connecting piece 11. An inner circumferential surface of each of the through-holes 12 is covered with an electrically conductive material.

The mother board 2 is one that is to be mounted with various integrated circuits and other electronic circuit parts, and one end edge (front end edge) thereof is provided with a plurality (eight in the diagram) of connecting holes 21 that penetrate in a thickness direction and are to be inserted with the respective connecting pieces 11. Each of the connecting holes 21 is rectangular shaped in a plan view, and a circumferential part and inner circumferential surface thereof is formed with a second connecting pattern 20 that is to be electrically connected to the first connecting pattern 10 and made of an electrically conductive material.

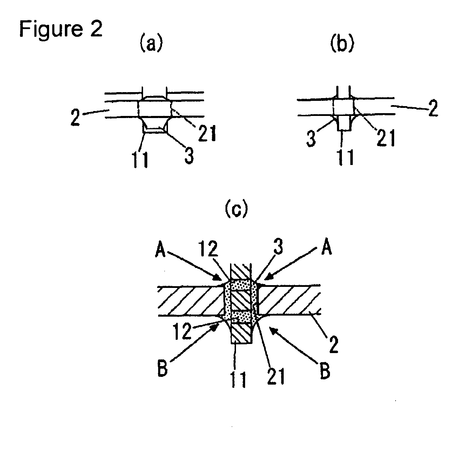

In the following, connections between the respective boards 1 and 2 in the present embodiment are described with use of the drawings. First, the respective connecting pieces 11 of the child board 1 are inserted into the respective connecting holes 21 of the mother board 2 from an upper surface side of the mother board 2. Then, the first connecting patterns 10 of the connecting pieces 11 and the second connecting patterns 20 of the connecting holes 21 are joined to each other by soldering. Note that, as a method for the soldering, a flow method that is generally used is employed. That is, by passing the respective boards 1 and 2 through a solder bath with the respective connecting pieces 11 being inserted into the respective connecting holes 21, and flowing a solder jet generated in the solder bath toward a lower surface of the mother board 2, the soldering is performed. Solder 3 passes through the respective connecting holes 21 to reach the upper surface of the mother board 2, and on both of the upper and lower surfaces of the mother board 2, forms solder fillets as illustrated in Figs. 2 (a) and (b).

Note that, at the time of the soldering, parts of the through-holes 12 are exposed outside the connecting holes 21. In particular, in the present embodiment, as illustrated in Fig. 1 (b), parts of the upper through-holes 12 are exposed on the upper surface side of the mother board 2, and parts of the lower through-holes 12 are exposed on the lower surface side of the mother board 2. By performing the soldering in this state, the child board 1 and the mother board 2 are joined to each other in the form as illustrated in Fig. 2 (c).

Based on the configuration as described above, at the time of the soldering, the solder 3 is filled in the through-holes 12 and sites near the upper and lower surfaces of the mother board 2 in connecting sites are joined by the solder through the through-holes 12, and therefore in the joint areas, a sufficient amount of the solder 3 can be ensured to enhance joint strength. Note that if, as in the conventional examples, the respective boards 1 and 2 are contained in a case (not illustrated), which is then filled with resin (not illustrated), the resin is expanded or contracted by a temperature difference occurring between circuit operation and stop states, and thereby connecting sites of the respective boards 1 and 2 are applied with stress. In such a case, the stress is applied in directions indicated by arrows A and B illustrated in Fig. 2 (c); however, in the present embodiment, the joint strength in the connecting sites is enhanced as described above, and therefore even if the stress is externally applied to the connecting sites, a failure such as a crack does not occur. Thus, good and reliable electrical connections can be achieved. Also, it is not necessary to apply covers onto entire surfaces of the connecting pieces 11 as in the third conventional example, and therefore the child substrate 1 can be easily manufactured.

Note that in the present embodiment, the two through-holes 12 are provided in each of the connecting pieces 11; however, the number of the through-holes 12 is not limited to this. In the case of providing three or more through-holes 12, if at least two of the plurality of through-holes 12 have the above configuration, the same effect as above can be produced.

### (Second embodiment)

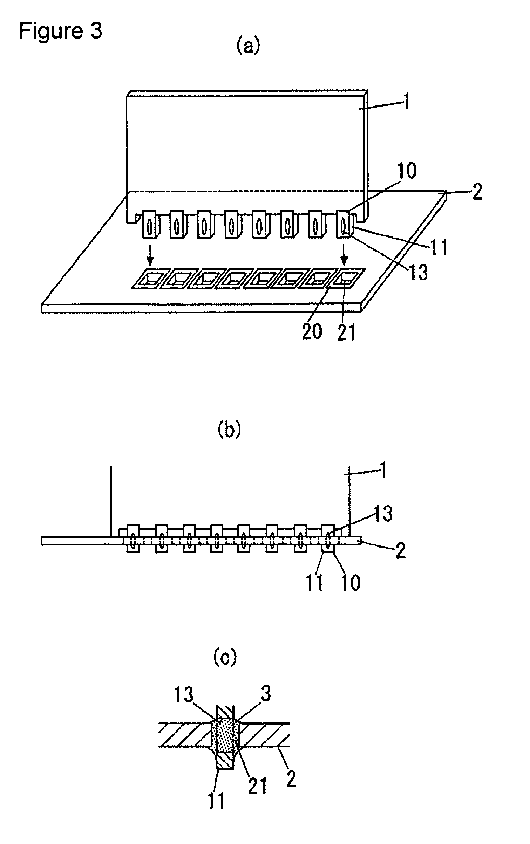

A second embodiment of the printed wiring board connecting structure according to the present invention is described below with use of the drawings. Note that a fundamental configuration of the present embodiment is common with the first embodiment, and therefore common sites are denoted by the same numerals to omit description. In addition, in the following description, directions between the top and bottom and between the right and left in Fig. 3 (b) are respectively defined as vertical and horizontal directions, and directions toward front and rear sides of the diagram are respectively defined as front and rear directions. In the present embodiment, as illustrated in Figs. 3 (a) and (b), each of connecting pieces 11 has one through-hole 13. The through-hole 13 has an elliptical shape in a plan view, of which a major axis is in a thickness direction (vertical direction) of a mother board 2, and configured such that, in a state where each of the connecting pieces 11 is inserted into each of connecting holes 21, both of upper and lower end parts thereof are respectively exposed on upper and lower sides of the mother board 2. By performing soldering in this state, a child board 1 and the mother board 2 are joined to each other in the form as illustrated in Fig. 3 (c).

Thus, at the time of the soldering, solder 3 is filled in the through-holes 13, and sites near upper and lower surface of the mother board 2 in connecting sites are joined by the solder through the through-holes 13, and therefore in the connecting areas, a sufficient amount of the solder 3 can be ensured to enhance joint strength. Also, a volume inside the through-hole 13, which is filled with the solder 3, is larger than that of the through-hole 12 of the first embodiment, and therefore the respective boards 1 and 2 can be joined to each other more tightly than in the first embodiment.

Note that, in each of the above-described embodiments, at the time of the soldering, the solder 3 should flow into the through-holes 12 or 13 to fill the through-holes 12 or 13. For this purpose, it is better for a horizontal (i.e., width direction of the connecting pieces 11) diameter size of the through-holes 12 or 13 to be larger, and preferably the diameter size is 0.3 mm or more. Also, the connecting pieces 11 should be provided with sufficient spaces respectively for providing the through-holes 12 or 13 and for the first connecting patterns 10 for making the electrical connections between the child board 1 and the mother board 2. For this purpose, a width size of the connecting pieces 11 is preferably 1.0 mm or more. Further, to ensure reliable electrical connections, a distance between an edge surface of each of the connecting pieces 11 and an edge surface of each of the through-holes 12 or 13 in the width direction of the connecting piece is preferably 0.2 mm or more.

Also, in each of the above-described embodiments, the soldering is performed on the basis of the flow method; however, the soldering may be performed on the basis of the other method, and for example, a soldering iron may be used to individually solder the respective connecting pieces 11. Even in such a case, it should be appreciated that the same effect as above can be produced.

### [Description of Reference Numerals]

1: Child board (first printed wiring board)
10: First connecting pattern
11: Connecting piece
12: Through-hole
2: Mother board (second printed wiring board)
20: Second connecting pattern
21: Connecting hole

## Claims

1. A printed wiring board connecting structure including:
a first printed wiring board (1) having a plurality of connecting pieces (11) each formed with a first connecting pattern (10) made of an electrically conductive material, the first connecting pattern (10) being formed on both surfaces in a thickness direction;
and a second printed wiring board (2) having a plurality of connecting holes (21) that penetrate in a thickness direction and are to be inserted with the respective connecting pieces (11),
the printed wiring board connecting structure being configured such that a circumferential part and an inner circumferential surface of each of the connecting holes (21) is formed with a second connecting pattern (20) that is to be electrically connected to the first connecting pattern (10) and made of an electrically conductive material, and by inserting each of the connecting pieces (11) into each of the connecting holes (21), and soldering the first connecting pattern (10) to the second connecting pattern (20), the first printed wiring board (1) and the second printed wiring board (2) are electrically and mechanically connected to each other,
wherein the connecting pieces (11) respectively have through-holes (12) that penetrate in the thickness direction and respectively have inner circumferential surfaces covered with an electrically conductive material, and upon the soldering, parts of the through-holes (12) are exposed outside the connecting holes (21),
wherein each of the connecting pieces (11) has a plurality of through-holes (12); a part of at least one of the through-holes (12) is, upon the soldering, exposed on one side in the thickness direction of the second printed wiring board (2); and a part of at least one of the other through-holes (12) is, upon the soldering, exposed on the other side in the thickness direction of the second printed wiring board (2).

2. A printed wiring board connecting structure including:
a first printed wiring board (1) having a plurality of connecting pieces (11) each formed with a first connecting pattern (10) made of an electrically conductive material, the first connecting pattern (10) being formed on both surfaces in a thickness direction;
and a second printed wiring board (2) having a plurality of connecting holes (21) that penetrate in a thickness direction and are to be inserted with the respective connecting pieces (11),
the printed wiring board connecting structure being configured such that a circumferential part and an inner circumferential surface of each of the connecting holes (21) is formed with a second connecting pattern (20) that is to be electrically connected to the first connecting pattern (10) and made of an electrically conductive material, and by inserting each of the connecting pieces (11) into each of the connecting holes (21), and soldering the first connecting pattern (10) to the second connecting pattern (20), the first printed wiring board (1) and the second printed wiring board (2) are electrically and mechanically connected to each other,
wherein the connecting pieces (11) respectively have through-holes (13) that penetrate in the thickness direction and respectively have inner circumferential surfaces covered with an electrically conductive material, and upon the soldering, parts of the through-holes (13) are exposed outside the connecting holes (21),
wherein each of the connecting pieces (11) has one through-hole (13), the through-hole (13) has an elliptical shape in a plan view, the elliptical shape having a major diameter in the thickness direction of the second printed wiring board (2); and parts of the through-hole (13) are, upon the soldering, exposed on both sides in the thickness direction of the second printed wiring board (2).

## Patentansprüche

1. Leiterplatinenverbindungsanordnung aufweisend:
eine erste Leiterplatine (1) mit einer Mehrzahl von Verbindungsteilen (11), die jeweils mit einer aus einem elektrisch leitfähigen Material hergestellten ersten Verbindungsstruktur (10) versehen sind, wobei die erste Verbindungsstruktur (10) in einer Dickenrichtung gesehen auf beiden Seiten angeordnet ist;
und eine zweite Leiterplatine (2) mit einer Mehrzahl von Verbindungslöchern (21), die sich in einer Dickenrichtung erstrecken und in die die betreffenden Verbindungsteile (11) einzustecken sind,
wobei die Leiterplatinenverbindungsanordnung dazu eingerichtet ist, dass ein Umfangsteil und eine innere Umfangsfläche jedes Verbindungsloches (21) mit einer zweiten Verbindungsstruktur (20) versehen ist, die elektrisch mit der ersten Verbindungsstruktur (10) zu verbinden und aus einem elektrisch leitfähigen Material hergestellt ist und wobei durch Einstecken jedes Verbindungsteils (11) in das jeweilige Verbindungsloch (21) und durch Löten der ersten Verbindungsstruktur (10) an die zweite Verbindungsstruktur (20), die erste Leiterplatine (1) und die zweite Leiterplatine (2) elektrisch und mechanisch miteinander verbunden sind,
wobei die Verbindungsteile (11) jeweils Durchgangslöcher (12) aufweisen, die sich in der Dickenrichtung erstrecken und jeweils innerre Umfangsflächen aufweisen, die mit einem elektrisch leitfähigen Material beschichtet sind, und wobei beim Löten Teile der Durchgangslöcher (12) außerhalb der Verbindungslöcher (21) angeordnet sind,
wobei jedes Verbindungsteil (11) mehrere Durchgangslöcher (12) aufweist; ein Teil von wenigstens einem der Durchgangslöcher (12) ist beim Löten in Dickenrichtung gesehen auf einer Seite der zweiten Leiterplatine (2) angeordnet; und ein Teil von wenigstens einem der anderen Durchgangslöcher (12) ist beim Löten auf der in Dickenrichtung gesehen anderen Seite der zweiten Leiterplatine (2) angeordnet.

2. Leiterplatinenverbindungsanordnung aufweisend:
eine erste Leiterplatine (1) mit einer Mehrzahl von Verbindungsteilen (11), die jeweils mit einer aus einem elektrisch leitfähigen Material hergestellten ersten Verbindungsstruktur (10) versehen sind, wobei die erste Verbindungsstruktur (10) in einer Dickenrichtung gesehen auf beiden Seiten angeordnet ist;
und eine zweite Leiterplatine (2) mit einer Mehrzahl von Verbindungslöchern (21), die sich in einer Dickenrichtung erstrecken und in die die betreffenden Verbindungsteile (11) einzustecken sind,
wobei die Leiterplatinenverbindungsanordnung dazu eingerichtet ist, dass ein Umfangsteil und eine innere Umfangsfläche jedes Verbindungsloches (21) mit einer zweiten Verbindungsstruktur (20) versehen ist, die elektrisch mit der ersten Verbindungsstruktur (10) zu verbinden und aus einem elektrisch leitfähigen Material hergestellt ist und wobei durch Einstecken jedes Verbindungsteils (11) in das jeweilige Verbindungsloch (21) und durch Löten der ersten Verbindungsstruktur (10) an die zweite Verbindungsstruktur (20), die erste Leiterplatine (1) und die zweite Leiterplatine (2) elektrisch und mechanisch miteinander verbunden sind,
wobei die Verbindungsteile (11) jeweils ein Durchgangsloch (13) aufweisen, dass sich in die Dickenrichtung erstreckt und die Durchgangslöcher (13) jeweils eine innere Umfangsfläche aufweisen, die mit einem elektrisch leitfähigen Material beschichtet ist, und wobei beim Löten Teile der Durchgangslöcher (13) außerhalb der Verbindungslöcher (21) angeordnet sind,
wobei jedes der Verbindungsteile (11) ein Durchgangsloch (13) aufweist, wobei das Durchgangsloch (13) in Draufsicht eine elliptische Form aufweist, wobei die elliptische Form eine in Dickenrichtung der zweiten Leiterplatine (2) verlaufende Hauptachse aufweist; und wobei Teile des Durargangsloches (13) beim Löten in Dickenrichtung der zweiten Leiterplatine (2) auf beiden Seiten angeordnet sind.

## Revendications

1. Structure de connexion de cartes de circuit imprimé comprenant :
une première carte de circuit imprimé (1) comportant une pluralité de pièces de connexion (11) munies chacune d'une première impression de connexion (10) faite d'un matériau électriquement conducteur, la première impression de connexion (10) étant formée sur les deux surfaces dans une direction d'épaisseur ;
et une deuxième carte de circuit imprimé (2) comportant une pluralité de trous de connexion (21) qui pénètrent dans une direction d'épaisseur et dans lesquels doivent être insérées les pièces de connexion (11) respectives,
la structure de connexion de cartes de circuit imprimé étant configurée de telle manière qu'une partie périphérique et une surface périphérique intérieure de chacun des trous de connexion (21) est pourvue d'une deuxième impression de connexion (20) qui est destinée à être connectée électriquement à la première impression de connexion (10) et qui est faite d'un matériau électriquement conducteur, et en insérant chacune des pièces de connexion (11) dans chacun des trous de connexion (21), et en soudant la première impression de connexion (10) à la deuxième impression de connexion (20), la première carte de circuit imprimé (1) et la deuxième carte de circuit imprimé (2) sont électriquement et mécaniquement connectées l'une à l'autre,
dans laquelle les pièces de connexion (11) comportent respectivement des trous traversants (12) qui pénètrent dans la direction d'épaisseur et qui ont respectivement des surfaces périphériques intérieures recouvertes d'un matériau électriquement conducteur, et après le soudage, des parties des trous traversants (12) sont exposées à l'extérieur des trous de connexion (21),
dans laquelle chacune des pièces de connexion (11) comporte une pluralité de trous traversants (12) ; une partie d'au moins l'un des trous traversants (12) est, après le soudage, exposée sur un côté dans la direction d'épaisseur de la deuxième carte de circuit imprimé (2) ; et une partie d'au moins l'un des trous traversants (12) est, après le soudage, exposée sur l'autre côté dans la direction d'épaisseur de la deuxième carte de circuit imprimé (2).

2. Structure de connexion de cartes de circuit imprimé comprenant :
une première carte de circuit imprimé (1) comportant une pluralité de pièces de connexion (11) munies chacune d'une première impression de connexion (10) faite d'un matériau électriquement conducteur, la première impression de connexion (10) étant formée sur les deux surfaces dans une direction d'épaisseur ;
et une deuxième carte de circuit imprimé (2) comportant une pluralité de trous de connexion (21) qui pénètrent dans une direction d'épaisseur et dans lesquels doivent être insérées les pièces de connexion (11) respectives,
la structure de connexion de cartes de circuit imprimé étant configurée de telle manière qu'une partie périphérique et une surface périphérique intérieure de chacun des trous de connexion (21) est pourvue d'une deuxième impression de connexion (20) qui est destinée à être connectée électriquement à la première impression de connexion (10) et qui est faite d'un matériau électriquement conducteur, et en insérant chacune des pièces de connexion (11) dans chacun des trous de connexion (21), et en soudant la première impression de connexion (10) à la deuxième impression de connexion (20), la première carte de circuit imprimé (1) et la deuxième carte de circuit imprimé (2) sont électriquement et mécaniquement connectées l'une à l'autre,
dans laquelle les pièces de connexion (11) comportent respectivement des trous traversants (13) qui pénètrent dans la direction d'épaisseur et qui ont respectivement des surfaces périphériques intérieures recouvertes d'un matériau électriquement conducteur, et après le soudage, des parties des trous traversants (13) sont exposées à l'extérieur des trous de connexion (21),
dans laquelle chacune des pièces de connexion (11) comporte un trou traversant (13), le trou traversant (13) a une forme elliptique en vue en plan, la forme elliptique ayant un grand diamètre dans la direction d'épaisseur de la deuxième carte de circuit imprimé (2) ; et des parties du trou traversant (13) sont, après le soudage, exposées des deux côtés dans la direction d'épaisseur de la deuxième carte de circuit imprimé (2).
